# EUROPEAN PATENT APPLICATION

(11) **EP 4 725 681 A1**
(43) Date of publication of application: **15.04.2026**
(21) Application number: 24205785.9
(22) Date of filing: 10.10.2024
(51) Int. Cl.: B29C 64/124, B29C 64/282, B33Y 10/00, B33Y 30/00, B33Y 70/00, G03F 7/00

(54) **PROCESS FOR VOLUMETRIC PRINTING OF A BIO-COMPATIBLE STARTING MATERIAL**

(71) Applicant: Xolo GmbH, 12489 Berlin (DE)
(72) Inventor: König, Niklas Felix, 12043 Berlin (DE)
(74) Representative: Erbacher, Martin

(57) **Abstract**

The present invention relates to a process for volumetric printing of a shaped body comprising locally polymerizing a starting material comprising a bio-co-initiator.

## Description

### Field of invention

The present invention relates to a process for volumetric printing of a shaped body comprising locally polymerizing a bio-compatible starting material.

### Background of Art

Among the many known techniques for additive manufacturing or 3D-printing, volumetric printing techniques offer several advantages, especially when the printed object is supposed to be used in a biological context (bioprinting). Volumetric printing techniques allow the formation of constructs with increased complexity compared to conventional 3D printing techniques, as they intrinsically don't require support structures and allow for printing of soft hydrogel objects. Light based volumetric printing techniques comprise the solidification of specific voxels within a volume of a photopolymerizable resin. Volumetric printing technologies include, but are not limited to: xolography, computed axial lithography/tomographic reconstruction, multiphotonpolymerisation, or cone beam lithography.

In xolography, light of two different wavelengths is intersected in a volume of resin. At the intersection voxels a polymerization is induced, which cause the resin to solidify. By changing the positions of intersection in the volume a shaped body with a specific geometry can be solidified. The process can involve a photoswitchable photoinitiator and a co-initiator which has been disclosed in WO2020245456A1 and WO2021089090A1.

Another implementation of volumetric printing relies on two photon polymerization, where a common photoinitiator is excited by the simultaneous uptake of two photons, causing polymerization in the focus of a laser beam [S. Maruo et al., Opt Lett., 1997, 22, 132- 134]. Two photon polymerization requires costly and delicate setups with intense pulsed laser sources. Furthermore, the technique is inherently slow due to the nonlinearity of the process, reducing the achievable object size considerably.

Furthermore, the method of computed axial lithography or tomographic reconstruction has been developed, where the resin is illuminated with different light patterns from various angles. Due to the overlaying light an intensity distribution in the volume is generated, which causes curing wherever a certain threshold is exceeded. The light patterns which are required to form a three-dimensional object are calculated before in a similar way to a reverse process of computer tomographic analysis [Kelly et al., US20180326666A1, 2018; Shusteff et al., US20180015672A1, 2018; Delrot et al. WO2019043529A1, 2019].

In a similar approach to the method of computed axial lithography or tomographic reconstruction, cone beam lithography has been proposed by Vitro3D. In cone beam lithography an image is projected, wherein the image size increases with increasing distance from the light source. More specifically the light path can be in a cone shape or truncated cone shape or in a shape which resembles a pyramid or truncated pyramid with a quadratic or rectangular base. By moving the light source relative to the resin, each voxel of the resin can experience irradiation from different angles. By changing the image for each relative position of irradiation and resin, each voxel can absorb a specific light dose leading to solidification of the resin in the shape of the voxels which have absorbed a light dose above a threshold light dose. As such the method of cone beam lithography can be similar to the reverse process of cone beam reconstruction.

Although volumetric printing may offer several advantages for printing a bio-compatible material, the development of such materials has been restricted to certain limitations. Typical bio-compatible materials may include larger biomolecules or even cells. Cells or larger biomolecules such as proteins may cause scattering, which is a serious problem in volumetric printing as the light has to penetrate into the volume. Scattering media typically lead to a lower resolution of the printed object, if the object is printable at all. In materials which include cells, the cells may be harmed during the irradiation process. Scattering and cell damage could be reduced by using longer wavelength irradiation such as visible light or near-infrared light irradiation.

In volumetric printing no bio-compatible material has been developed, which can be solidified with visible light.

It is, therefore, the object of the present invention to provide a process for volumetric printing of a shaped body overcoming drawbacks of the prior art, especially to provide a process allowing volumetric printing of a shaped body from a bio-compatible starting material.

### Disclosure of the invention

The object of the present invention is achieved by a process for volumetric printing of a shaped body comprising locally polymerizing a starting material, comprising:
- providing a polymerizable starting material, wherein the polymerizable starting material comprises
   - a photoinitiator;
   - a polymerizable compound;
   - a bio-co-initiator; and
   - water; and
   - the polymerizable starting material has a pH value from 5 to 9;
- photopolymerizing the polymerizable starting material in a local volume by irradiating light of a first wavelength.

The polymerizable starting material may contain the following parts by weight:
- 1 -99.9999 wt%, preferably 5-99.99 wt%, more preferably 20-99.9 wt% of photopolymerizable compound(s), e.g. monomer(s);
- 0-50wt%, preferably 1-40 wt%, more preferably 3-10 wt% of bio-co-initiator, when the co-initiator does not contain photopolymerizable groups;
- 0.0001-20 wt%, preferably 0.001-10 wt%, more preferably 0.01-5 wt%, most preferably 0.1-1 wt% of dual color photoinitiator;
- 1- 99 wt%, preferably 50-99 wt%, more preferably 70-95 wt% of water.

All weight percentages are given with respect to the weight of the total polymerizable starting material.

In one embodiment, the polymerizable starting material is photopolymerized in a local volume by irradiating light of a first wavelength and light of a second wavelength, wherein the light of the first wavelength and the light of the second wavelength can be intersected in the local volume.

In one embodiment,
- the photoinitiator is converted by sequential optical excitation into a reactive state in which the photoinitiator locally triggers polymerization of the polymerizable starting material;
- the photopolymerizing comprises irradiating the starting material in the local volume further with light of a second wavelength, different from the first wavelength, into the local volume;
- the photoinitiator is converted, due to the absorption of the light of the first wavelength, from an initial state in which the photoinitiator substantially does not absorb the light of the second wavelength, into an intermediate state with changed optical properties compared to the initial state, such that the photoinitiator in the intermediate state absorbs the light of the second wavelength; and
- the photoinitiator is transferred from the intermediate state to the reactive state due to the absorption of the light of the second wavelength, which triggers the polymerization locally.

In this embodiment, a process for volumetric printing of a shaped body from a starting material by means of dual color photopolymerization is provided. Here a polymerizable starting material is provided which contains a photoinitiator (= photoinitiator molecules) which can be converted by means of sequential optical excitation with several wavelengths into a reactive state in which the photoinitiator molecules locally trigger a polymerization of the starting material, in particular a local curing or hardening of the starting material due to the polymerization. The starting material is photopolymerized in a local volume by irradiating light of a first wavelength simultaneously with or followed by light of a second wavelength different from the first wavelength into the local volume.

In the local volume is provided that, by absorption of a photon of the first wavelength, the photoinitiator molecules are converted from an initial state, in which the photoinitiator molecules do not substantially absorb the light of the second wavelength, to an intermediate state with optical properties different from those of the initial state, in such a way that the photoinitiator molecules in the intermediate state absorb the light of the second wavelength and enter the reactive state. In the local volume, due to the gradual absorption of the light of the first wavelength and the light of the second wavelength, the photoinitiator molecules are transferred from the initial state via the intermediate state into the reactive state, which locally triggers polymerization. Outside of the local volume the photoinitiator molecules which have been in the intermediate state return to the initial state.

According to another aspect, an apparatus for local polymerization of a starting material by means of dual color photopolymerization is created. The apparatus comprises the following: a container for a polymerizable starting material, light generating means arranged to provide light of a first wavelength and light of a second wavelength, the second wavelength being different from the first wavelength, and light guide means arranged to irradiate the light of the first wavelength and the light of the second wavelength into a local volume. The apparatus is arranged to perform the following processes: taking up the polymerizable starting material by the container, the starting material containing photoinitiator molecules which can be converted by means of sequential optical excitation into a reactive state in which the photoinitiator molecules locally trigger polymerization of the starting material, and thus result in photopolymerization of the starting material in a local volume by means of irradiation of the light of the first wavelength and the light of the second wavelength in a defined local volume. The following is provided in the local volume: the photoinitiator molecules are converted from an initial state, in which the photoinitiator molecules essentially do not absorb the light of the second wavelength, into an intermediate metastable ground state with changed optical properties compared to the initial state due to absorption of a photon of the first wavelength, in such a way that the photoinitiator molecules in the intermediate state absorb the light of the second wavelength. In the local volume, due to the gradual absorption of light of the first wavelength and light of the second wavelength, the photoinitiator molecules are converted from the initial state via the intermediate state into the reactive state, which locally triggers polymerization. Outside of the local volume the photoinitiator molecules which have been in the intermediate state return to the initial state.

According to one aspect, the apparatus for local polymerization of a starting material by means of dual color photopolymerization can comprise a container which can be at least partially filled with the photopolymerizable starting material.

According to another aspect, the container can comprise a working volume, wherein the working volume comprises the photopolymerizable starting material, especially the volume of the photopolymerizable starting material, which is irradiated with light of at least one of light of a first wavelength and light of a second wavelength.

According to one aspect, the light of the first wavelength is provided as a light sheet and the light of the second wavelength is provided as an image, wherein the position of the light sheet with respect to the working volume can be changed, preferably in a translational motion, and the image can be changed depending on the position of light sheet. To give an example, a container containing the photopolymerizable starting material is moved relative to a light sheet, while a movie is projected onto the light sheet from an orthogonal direction.

In the process for volumetric printing of a shaped body, the local photopolymerisation leads to hardening or curing of the starting material and thus to production of the shaped body.

The absorptive capacity of the photoinitiator molecules in the intermediate state with respect to light of the second wavelength can be based on a change in the optical properties of the photoinitiator molecules, by which the absorptive capacity for light of the second wavelength is initially formed, in particular in that a spectral absorption band is formed in the region of the second wavelength due to the transition from the initial state to the intermediate state. Alternatively, it can be provided that an absorption band for light of the second wavelength already existing in the initial state of the photoinitiator molecules is amplified or enlarged in the intermediate state.

In the intermediate state, the photoinitiator molecules in the range of the first wavelength may be still absorbing or no longer absorbing. More preferred, the photoinitiator molecules in the intermediate state may substantially not absorb the light of the first wavelength. Most preferred, the photoinitiator molecules in the intermediate state may not absorb the light of the first wavelength.

In one aspect, the intermediate state may return thermally at the printing temperature in the printing resin to the initial state. Preferably, the intermediate state may return thermally at the printing temperature to the initial state in a mechanism with one or more rate constants with the highest rate constant higher than k=0.01 s⁻¹. Especially preferably, at least one rate constant for the thermal back reaction is higher than 0.02 s⁻¹, more preferably, higher than 0.05 s⁻¹, even more preferably higher than 0.08 s⁻¹, most preferably higher than 0.25 s⁻¹, but optionally not higher than 0.65 s⁻¹. Hence, at least one rate constant may be in the range of 0.1 s⁻¹ and 0.65 s⁻¹, or any other range which may be formed from the values above. In the various embodiments, local photopolymerization in the local area can lead to hardening or curing of the starting material.

Light of the first and second wavelength can be irradiated simultaneously into the local volume.

Light of the second wavelength can be irradiated into the local volume after the irradiation of the light of the first wavelength into the local volume has ended, the light of the second wavelength being irradiated before the end of a decay time of the intermediate state of the photoinitiator molecules.

Due to the absorption of light of the second wavelength, the photoinitiator molecules can be converted into a reactive state, which triggers polymerization in the local volume. It may be intended that this reactive state is produced in analogy to a Norrish type I reaction or a Norrish type II reaction which is known to the skilled person. Alternatively, it may be intended that this reactive state undergoes an electron transfer reaction with a co-initiator.

Dual color photoinitiators can be used, which respond to electromagnetic radiation of a first wavelength by switching from a thermodynamically stable state A to a metastable state B. B is able to absorb electromagnetic radiation of a second wavelength, thereby forming C, that can initiate a polymerization reaction. B can undergo a fast thermal reverse reaction to form A and is then deactivated for electromagnetic radiation of the second wavelength. Application of such dual color photoinitiators allows the curing of a photopolymerizable resin in any volume, where electromagnetic radiation of both wavelengths intersects, for example where an image is projected on a light sheet. Certain substitution patterns ensure a fast thermal back reaction and no curing with the first wavelength alone, preventing the curing in unwanted areas. Application of the disclosed dual color photoinitiators in a polymerizable mixture allows fast volumetric printing with high resolution. No support structures are required, which saves material and allows for the fabrication of soft and fragile products. A broad range of possible resin viscosities can be covered, and high reactivity is achieved, due to minimized quenching of the polymerization by oxygen and water. The utilization of the disclosed dual color photoinitiators allows faster printing than common photopolymerization based additive manufacturing techniques due to fewer mechanical operations.

The dual color photoinitiators may be characterized in a way that a polymerization is induced where electromagnetic radiation of two different wavelengths interacts with the same volume of polymerizable material in a simultaneous or consecutive fashion. In volumes which interact with electromagnetic irradiation of only one wavelength, less or no polymerization is induced.

A dual color photoinitiator in the thermodynamically stable form A may absorb a photon from electromagnetic radiation of the first wavelength which induces an isomerization reaction to the metastable form B. The dual color photoinitiator in the metastable form B absorbs a photon from electromagnetic radiation of the second wavelength, which results in an excited state C and further causes the formation of radicals by hydrogen abstraction from a co-initiator followed by electron transfer or decomposition into radicals, by electron transfer which is followed by hydrogen abstraction or decomposition into radicals, or homolytic bond cleavage which can be preceded or followed by other rearrangement reactions to form radicals. Dual color photoinitiators in the metastable state B which have not absorbed a photon from electromagnetic radiation of the second wavelength, return spontaneously via a thermal process to the thermodynamically stable state A.

The dual color photoinitiators may carry carbonyl functions which are weak triplet sensitizers for spiropyrans and related structures and therefore show no curing with UV light alone. Electromagnetic radiation of the first wavelength causes excitation of the initiator in form A and switching to the initiator in form B mainly via a singlet state. The efficient ring opening reaction of the photoswitch motif prevents the dual color initiators from radical formation by irradiation with the first wavelength alone. The merocyanine type form B can act as an internal triplet sensitizer upon irradiation with the second wavelength, which causes the carbonyl group to abstract a hydrogen atom from a co-initiator, undergo an electron transfer reaction, or undergo homolytic bond cleavage. The substituents are chosen in a way to minimize or extinguish the absorption of the merocyanine type form B at the first wavelength and that form B is thermodynamically destabilized to ensure a fast thermal back reaction from B to A. Furthermore, the disclosed dual color initiators benefit from an exceptionally low or neglectable quantum yield for the competing photoreaction from B to A and high extinction coefficients of the B form, where form A does not absorb. The merocyanine form B typically has a broad absorption in the visible region, which allows for high intensities over a broad range of wavelengths.

According to one aspect the intermediate state B can be an excited triplet state and/or the reactive state C can be a higher excited state, preferably a higher excited triplet state.

Due to the absorption of the light of the second wavelength, the photoinitiator molecules can be converted into a reactive state which triggers a radical polymerization in the local volume.

A light beam of light of the first wavelength and a light beam of light of the second wavelength can be irradiated in the local volume at least partially overlapping.

A light sheet of light of the first wavelength and an image projection of light of the second wavelength can be irradiated in the local volume at least partially overlapping.

The starting material can be polymerized in several local volumes by means of photo polymerization and thus a three-dimensional shaped body can be produced in the starting material.

The dual color initiators are not limited to a specific setup, but to give an illustrative example which shows the necessity of the thermal back reaction the following setup can be used: Volumetric printing can be conducted in a setup, which consists of a light sheet generator, a projector, a container that has four transparent sides and contains the resin including at least one of the disclosed dual color photoinitiators and a moveable stage to move either the container or the light sheet generator. Such a setup ensures a fast curing process over the whole volume, compared to the point by point setups described by Swainson [Swainson, US4041476, US4078229, US4238840, US4466080, US4471470, US4333165]. One layer of a volume is irradiated with electromagnetic radiation of a first wavelength to switch the dual color photoinitiators from A to B. An image is projected on that layer from a different direction, using electromagnetic radiation of the second wavelength, which induces a photopolymerization, where image and layer overlay. After a given amount of time, the electromagnetic radiation of the first wavelength is shifted to a neighboring layer and the next image is projected on this layer with electromagnetic radiation of the second wavelength. In the previous layer no further polymerization occurs due to the fast thermal back reaction to the A form, which causes a deactivation for electromagnetic radiation of the second wavelength. After a number of iteration steps, the 3-dimensional object is cured in the volume and can be taken out, or the residual resin can be washed away. The remaining object can be subjected to a post-processing.

In one embodiment,
- the light of the first wavelength is irradiated into the local volume from a first direction and from a second direction different from the first direction;
- the light of the first wavelength irradiated into the local volume from the first direction has a first intensity or a first intensity distribution;
- the light of the first wavelength irradiated into the local volume from the second direction has a second intensity or a second intensity distribution

The first intensity or first intensity distribution can be different from the second intensity or second intensity distribution. The first intensity can be different from the second intensity. The first intensity distribution can be different from the second intensity distribution

Irradiating the photopolymerizable starting material from at least two different directions (including the first direction and the second direction) can be achieved by at least one of:
- motion of the local volume relative to at least one (static) radiation device emitting light of a first wavelength;
- motion of at least one radiation device emitting the light of the first wavelength relative to the (static) local volume
- motion of the local volume and motion of at least one irradiation device emitting the light of a first wavelength.

As such, the local volume and/or the radiation device can be moveably supported in at least one degree of freedom of motion which can be or comprise a translatory and/or rotatory degree of freedom of motion.

In either case, irradiating the photopolymerizable starting material can be effected simultaneously or sequentially with moving the local volume relative to the at least one radiation device. Typically, the resulting intensity distribution within the local volume depends on the intensity of the light, the irradiation direction, the irradiation location, the absorption properties of the photopolymerizable staring material and the absorption properties of the photopolymerized material, respectively.

The irradiating of the photopolymerizable starting material with light of the first wavelength into the local volume can be performed wherein the working volume is not moved relative to a radiation device and the radiation device is shaped in a way that light emitted from the radiation device travels different distances from the radiation device to the local volume, for example is shaped as conical or pyramidal.

One or more radiation device(s) can be used emitting the light of the first wavelength at a specific angle or a range of angles with respect to the surface of the photopolymerizable starting material, which includes other angles than 90°, preferably at least two angles different from 90°.

The light of the first wavelength can be irradiated into the local volume from more than two different directions (first direction, second direction, third direction etc.), preferably from five or more different directions.

The light of the first wavelength can be irradiated into the local volume in the form of an image, wherein the same image or different images can be irradiated from the different directions (first direction, second direction, third direction etc.). The light of the first wavelength may be irradiated into the local volume in parallel or diverging.

The intensity of the light of the first wavelength irradiated into the local volume from a first direction and the intensity of the light of the first wavelength irradiated into the local volume from a second direction (and optionally that of any further direction) may be selected to maximize the absorbed light (absorbed dose) in the local volume (to be polymerized) and to minimize the absorbed light (absorbed dose) in the remaining volume (not to be polymerized). It may be provided that the local volume (to be polymerized) is a volume in which a threshold of absorbed light is exceeded.

According to one aspect the polymerizable starting material has an optical density referring to an optical path length of 10 mm according to the Beer-Lambert law of 0.1 at at least one wavelength between 400 nm and 2000 nm, preferably at least one wavelength between 450 nm and 1900 nm, more preferably at least one wavelength between 500 nm and 1800 nm, even more preferably at least one wavelength between 600 nm and 1700 nm, still more preferably at least one wavelength between 800 nm and 1600 nm, most preferably at least one wavelength between 1000 nm and 1500 nm or any other ranges formed from values above. Alternatively, the polymerizable starting material is characterized by an optical density referring to an optical path length of 10 mm according to the Beer-Lambert law of 0.1 at at least one wavelength between 400 nm and 1000 nm, preferably at least one wavelength between 450 nm and 900 nm, more preferably at least one wavelength between 500 nm and 800 nm. The optical density can be measured using a Cary 60 UV-Vis Spectrophotometer from Agilent Technologies.

According to another aspect, the light of the first wavelength comprises light at least one wavelength between 400 nm and 1000 nm, wherein the highest intensity or peak emission is at a wavelength between 400 nm and 1000 nm, preferably at a wavelength between 450 nm and 900 nm, more preferably at a wavelength between 500 nm and 800 nm. According to this aspect, preferably only light of a first wavelength is irradiated into the local volume.

The first wavelength and/or the second wavelength can comprise a range of wavelengths, respectively.

According to one aspect, the light of the first wavelength and the light of the second wavelength each comprises light of at least one wavelength between 300 nm and 1000 nm, wherein the highest intensity or peak emission of the light of the first wavelength is at a lower wavelength than the wavelength of the highest intensity or peak emission of the light of the second wavelength.

Typical polymerization parameters which are suitable for volumetric printing may be:
- any setup which employs light as described above;
- a temperature of °C to +100 °C; preferably o °C to +60 °C, more preferably +20 °C to + 6o °C
- a first wavelength of: 300 nm to 500 nm; preferably, 325 nm to 450 nm, more preferably 350 nm to 425 nm and
- if used, a second wavelength of: 350 nm to 1000 nm, preferably 450 nm to 900 nm, more preferably 500 nm to 800 nm.

To prevent migration and release of remaining photoinitiator and/or their reaction products from the cured object the following measures are disclosed:
a) Substitution in a way, that the molecular weight exceeds 1000 g/mol
b) Binding of the photoinitiator to a structure of higher molecular weight, such as an oligomer or a polymer
c) Functionalization of the initiator with polymerizable groups, which are build in the polymer network during curing, these include but are not limited to: acrylates, acrylamides, methacrylates, thiol + ene, epoxides, oxiranes, oxetanes, vinylethers.

The polymerizable starting material may have a pH value selected from the group consisting of from 5.5 to 8.5, from 6 to 8, from 6.6 to 7.5, and from 7 to 8, such as about 7.4.

The bio-co-initiator may have a pKa value selected from the group consisting of from 4.5 to 8, from 5 to 8, from 5.5 to 8, from 6 to 8, from 6.1 to 7.9, from 6.2 to 7.8, from 6.20 to 7.76, from 6.3 to 7.5, from 6.4 to 7.3, from 6.48 to 7.19, from 6.2 to 6.8, from 6.3 to 6.7, from 6.4 to 6.6, such as about 6.48.

The pKa value of a bio-co-initiator can refer to the pKa of the bio-co-initiator at infinite dilution (bio-co-initiator concentration=0) and 25°C in water. Typical procedures to determine the pKa value of a bio-co-initiator and pKa values for specific compounds, which can be used as bio-co-initiators can be found in "CRC Handbook of Chemistry & Physics, 93th edition: Dissociation Constants of Organic Acids and Bases" or "Goldberg, R. N., Kishore, N., Lennen, R. M. J. Phys. Chem. Ref. Data, 31, 2002, 231-370"

The bio-co-initiator may be an amine comprising at least one beta-hydroxy group or a borate salt comprising a borate anion and a cation, wherein the cation may be selected from the group consisting of H⁺, Li⁺, Na⁺, K⁺, Mg²⁺, and Ca²⁺, preferably the cation is Li⁺.

The bio-co-initiator may be an amine comprising 1, 2, 3, 4, or 5 beta-hydroxy group(s). The bio-co-initiator may be an amine comprising 1, 2, 4, or 5 beta-hydroxy group(s). The bio-co-initiator may be an amine comprising at least four beta-hydroxy groups. The bio-co-initiator may be an amine comprising 4 or 5 beta-hydroxy groups. The bio-co-initiator may be an amine comprising 5 beta-hydroxy groups.

The bio-co-initiator may be a tertiary amine comprising 1, 2, 3, 4, or 5 beta-hydroxy group(s). The bio-co-initiator may be a tertiary amine comprising 1, 2, 4, or 5 beta-hydroxy group(s). The bio-co-initiator may be a tertiary amine comprising at least four beta-hydroxy groups. The bio-co-initiator may be a tertiary amine comprising 4 or 5 beta-hydroxy groups. The bio-co-initiator may be a tertiary amine comprising 5 beta-hydroxy groups.

The bio-co-initiator may be an amine comprising at least one 2-hydroxy-propyl group. The bio-co-initiator may be an amine comprising one 2-hydroxy-propyl group. The bio-co-initiator may be an amine comprising 1, 2, 3, 4, or 5 2-hydroxy-propyl group(s). The bio-co-initiator may be an amine comprising 4, or 5 2-hydroxy-propyl groups. The bio-co-initiator may be an amine comprising more than five 2-hydroxy-propyl groups.

The bio-co-initiator may be a tertiary amine comprising at least one 2-hydroxy-propyl group. The bio-co-initiator may be a tertiary amine comprising one 2-hydroxy-propyl group. The bio-co-initiator may be a tertiary amine comprising 1, 2, 3, 4, or 5 2-hydroxy-propyl group(s). The bio-co-initiator may be a tertiary amine comprising 4, or 5 2-hydroxy-propyl groups. The bio-co-initiator may be a tertiary amine comprising more than five 2-hydroxy-propyl groups.

The bio-co-initiator may be an amine comprising at least one beta- or gamma-sulfonate group. The bio-co-initiator may be an amine comprising one beta- or gamma-sulfonate. The bio-co-initiator may be a tertiary amine comprising at least one beta- or gamma-sulfonate. The bio-co-initiator may be a tertiary amine comprising one beta- or gamma-sulfonate. In this regard, it is preferred that the corresponding cation in the beta- or gamma-sulfonate groups is independently selected from the group consisting of H⁺, D⁺ Li⁺, Na+, K⁺, Mg²⁺, and Ca²⁺, more preferably H+, Na+, and K+.

The bio-co-initiator may be an amine comprising at least one beta-sulfonate group. The bio-co-initiator may be an amine comprising one beta-sulfonate group. The bio-co-initiator may be a tertiary amine comprising at least one beta-sulfonate group. The bio-co-initiator may be a tertiary amine comprising one beta-sulfonate group. In this regard, it is preferred that the corresponding cation in the beta-sulfonate group or groups is independently selected from the group consisting of H⁺, D⁺ Li⁺, Na⁺, K⁺, Mg²⁺, and Ca²⁺, more preferably H⁺, Na⁺, and K⁺.

The bio-co-initiator may be an amine functionalized with an ether in the beta position. The bio-co-initiator may be a tertiary amine functionalized with an ether in the beta position.

The bio-co-initiator may be comprise a morpholine structural moiety, a piperidine structural moiety, a piperazine structural moiety. The bio-co-initiator may be a tertiary amine comprising a morpholine structural moiety, a piperidine structural moiety, or a piperazine structural moiety, wherein the amine N is part of the morpholine structural moiety, the piperidine structural moiety, or the piperazine structural moiety,

Whenever reference is made to a specific number of specific functional groups in the bio-co-initiator or in another substance disclosed herein, it may be provided that the presence of further respective specific functional groups is excluded while other specific functional groups may be part of the bio-co-initiator. E.g. a bio-co-initiator comprising 4 or 5 beta-hydroxy groups may have exactly 4 or 5 beta-hydroxy groups and may comprise, in addition, other functional groups, such as, e.g. one or more beta-sulfonate groups.

The bio-co-initiator may be selected from "Good buffers" as disclosed in Goldberg, R. N., Kishore, N., Lennen, R. M. J. Phys. Chem. Ref. Data, 31, 2002, 231-370 and the following compounds, preferably from the following compounds

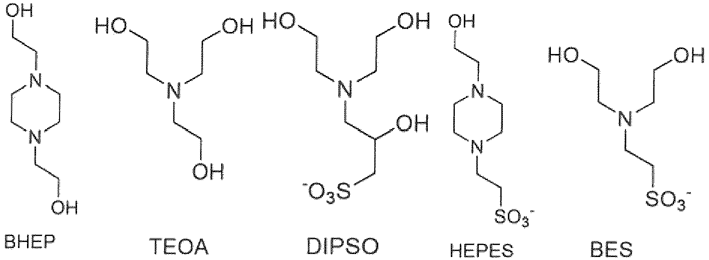

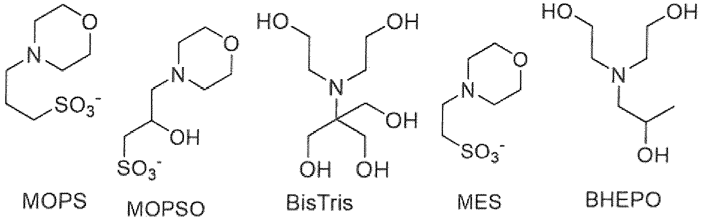

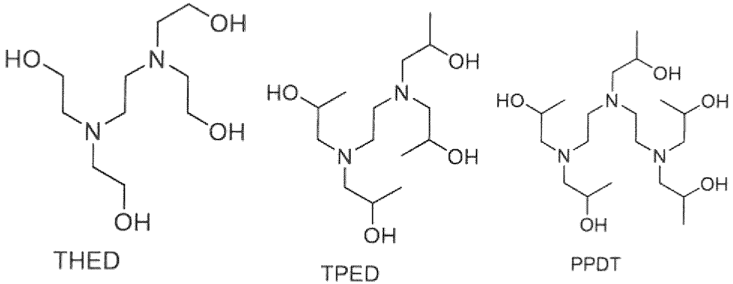

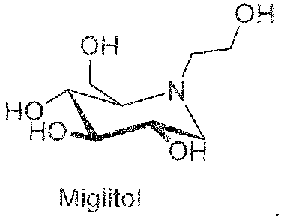

The bio-co-initiator may be borate salt, wherein the borate anion is represented by the following formula (I).

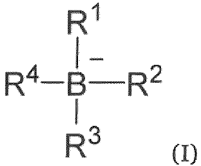

In formula (1), R¹ to R⁴ may be independently selected from the group consisting of alkyl, aryl, alkylaryl, allyl, arylalkyl, alkenyl, alkynyl, alicyclic hydrocarbon and saturated or unsaturated heterocyclic groups. In formula (I), R¹ to R⁴ may be independently selected from the group consisting of alkyl and aryl.

Representative examples of alkyl groups represented are methyl, ethyl, propyl, butyl, pentyl, hexyl, octyl, stearyl, etc. The alkyl groups may be branched. Representative examples of branched alkyl groups include iso-propyl, tert-butyl, sec-butyl, iso-butyl, neo-pentyl, isopentyl. The alkyl groups may be unsubstituted or substituted, for example, by one or more halogen, cyano, acyloxy, acyl, alkoxy or hydroxy groups. Representative examples of aryl groups represented are phenyl and naphthyl. The aryl groups may be unsubstituted or substituted, for example, by one or more halogen, cyano, acyloxy, alkyl, acyl, alkoxy or hydroxy group, preferably F or methyl. Alkylaryl may be methylphenyl, dimethyl phenyl, etc. A representative example of alkylaryl groups is benzyl. Representative alicyclic hydrocarbon groups include cyclobutyl, cyclopentyl, and cyclohexyl groups. Examples of an alkynyl group include propynyl and ethynyl, and examples of alkenyl groups include a vinyl group.

Preferably, at least one but not more than three of R¹ to R⁴ is an alkyl group. Each of R¹ to R⁴ can contain up to 20 carbon atoms, and they typically contain 1 to 7 carbon atoms.

More preferably, R¹ to R⁴ are selected from the group consisting of alkyl, aryl, and arylalkyl group(s) and still more preferably R¹ to R³ are aryl, preferably phenyl, and preferably R⁴ is alkyl, preferably butyl, that is, the borate anion may be a triarylalkylborate anion.

The cation of the borat salt can be selected from the group consisting of H⁺,D⁺, Li+, Na+, K+, Mg²⁺, Ca²⁺, preferably is Li⁺.

The photoinitiator may include a structural motif selected from the group consisting of a spiropyran structural motif, a spironaphthoxazine structural motif and a naphthopyran structural motif.

A spiropyran structural motif is a structure represented by the following formula (II)

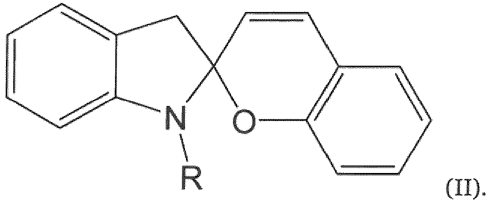

R is selected from H, D, substituted or unsubstituted C₁-C₄-alkyl, phenyl and benzyl. More preferred, R is methyl, -CH₂-CH₂-OH, phenyl or benzyl.

Suitable photoinitiators comprising a spiropyran structural motif are known, e.g., from WO 2020/245456 A1, WO2023220461A1, and WO2023034398A1

A spironaphthooxazine structural motif is a structure represented by one of the following formulas (IIIa) to (IIIc)

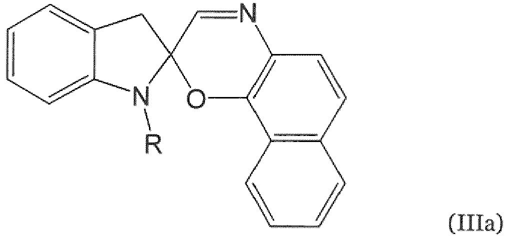

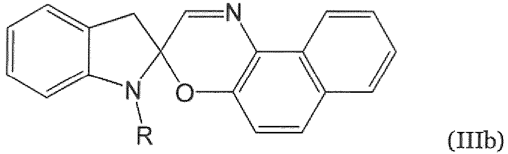

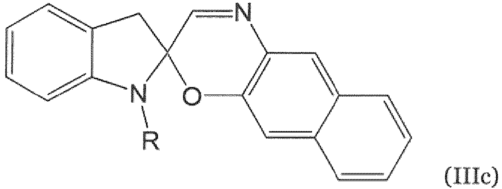

R is selected from H, D, substituted or unsubstituted C₁-C₄-alkyl, phenyl and benzyl. More preferred, R is methyl, -CH₂-CH₂-OH, phenyl or benzyl.

Suitable photoinitiators comprising a spironaphthoxazine structural motif are known, e.g., from WO2023220461A1 and WO2023034404A1

A naphthopyran structural motif is a structure represented by the following formula (IVa) to (IVc) 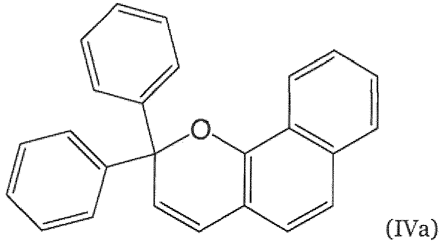 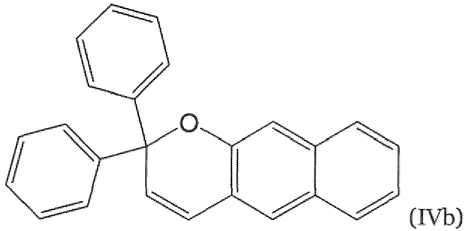 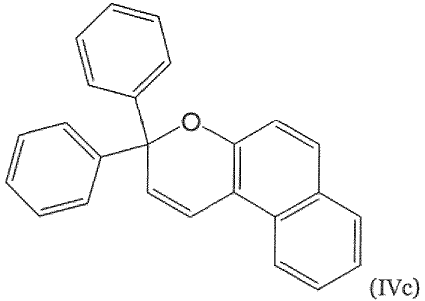 Suitable photoinitiators comprising a naphthopyran structural motif are known, e.g., from WO2023220461A1 and WO2023034402A1

The spiropyran structural motif, the spironaphthooxazine structural motif and the naphthopyran structural motif may be substituted with one or more substituents independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl and substituted or unsubstituted C₂-C₂₀-alkenyl; wherein the one or more substituents, if present in one or more of the substituents on the spiropyran structural motif, the spironaphthooxazine structural motif or the naphthopyran structural motif, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; (meth)acrylate; tosyl; NH₂; and OH; and/or wherein two adjacent groups on the spiropyran structural motif, the spironaphthooxazine structural motif or the naphthopyran structural motif may be linked to each other to form a fused ring structure, preferably, a fused aromatic C₆-ring.

In a further embodiment, it may be provided that the photoinitiator contains a functional group which increases the solubility in water.

The photoinitiator may further comprise, besides the structural motif selected from the group consisting of a spiropyran structural motif, a spironaphthooxazine structural motif and a naphthopyran structural motif, at least one group selected from the group consisting of ammonium, polyethylene glycol, OH, NH₂, SO₂NH₂, sulfonic acid, carboxylic acid; boronic acid; phosphonic acid, phosphates; phosphonates; sulfates; sulfonates; and carboxylates.

The photoinitiator may further comprise, besides the structural motif selected from the group consisting of a spiropyran structural motif, a spironaphthooxazine structural motif and a naphthopyran structural motif, at least one group selected from the group consisting of ammonium, polyethylene glycol, OH, NH₂, SO₂NH₂, sulfonic acid, boronic acid; phosphonic acid, phosphates; phosphonates; sulfates; and sulfonates.

The photoinitiator may include a spiropyran-based structural motif of formula (V)

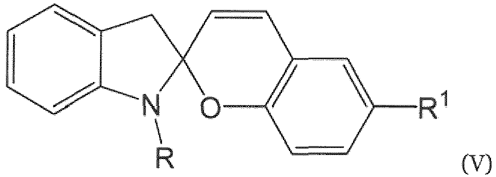

In the spiropyran-based structural motif of formula (V), R¹ is an electron withdrawing group.

The electron withdrawing group may be selected from the group consisting of CN, F, NO₂, ester, alkyl acyl, aryl acyl, SO₂R', such as SO₂CF₃, SO₂Me, or SO₂NH₂, SF₅, NR'₃⁺, pyridinium, aldehyde, amide, halogen, and fluorinated alkyls or aryls, such as CF₃.

Here alkyl acyl has the following formula 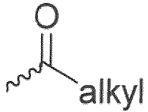 and arylacyl has the following formula 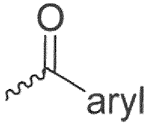 wherein the waved line represents the bond to the spiropyran structural motif.

R is selected from H, D, substituted or unsubstituted C₁-C₄-alkyl, phenyl and benzyl. Preferably the substituent of substituted C₁-C₄-alkyl is sulfonic acid, sulfonate, or NR'₃⁺ More preferred, R is methyl, -CH₂-CH₂-OH, phenyl or benzyl.

R¹ may be selected as having one the following structures: 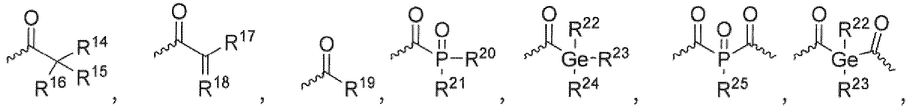 wherein R¹⁴ to R²⁵ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl and substituted or unsubstituted C₂-C₂₀-alkenyl; wherein the one or more substituents, if present in one or more of R¹⁴-R²⁵, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; (meth)acrylate; tosyl; NH₂; and OH; and R¹⁵ and R¹⁶ may be linked to each other to form a unsubstituted or substituted ring structure, such as a cyclohexyl ring, a cyclopently ring or a piperidine ring.

In one particular embodiment it may be provided that R¹ is selected from the group of electron withdrawing groups consisting of CF₃, SO₂Me, SO₂NH₂, CN, F, NO₂, C₆-aryl, unsubstituted C₆-arylacyl of the following formula 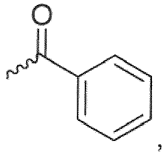 dimethoxy-substituted arylacyl of the formula 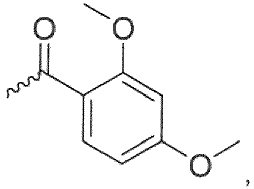 method-substituted arylacyl of the formula 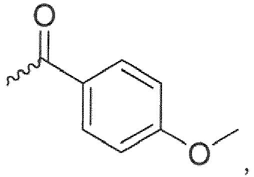 fluorine-substituted arylacyl of the following formula 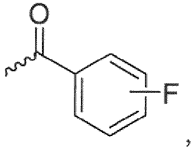 alternatively of the formula 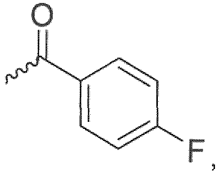 and C₆-aryl.

The photoinitiator may include a spiropyran-based structural motif of formula (VI) 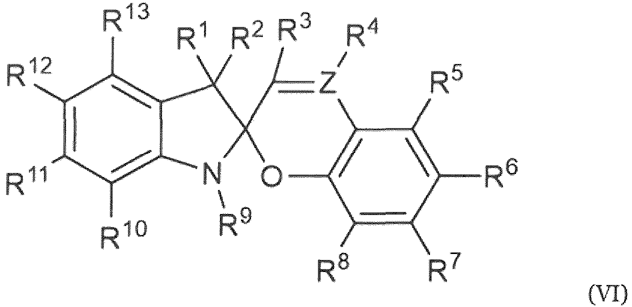 wherein
- R⁶ is an electron withdrawing group, preferably selected from the group consisting of be CN, F, NO₂, ester, alkyl acyl, aryl acyl, amide, formyl, SO₂R, such as SO₂CF₃, SO₂Me, or SO₂NH₂, SF₅, NR₃⁺, pyridinium, halogen, and fluorinated alkyls or aryls, such as CF₃, wherein embodiments described above for formula (V) are most preferred;
- preferably at least one of R¹⁰ to R¹³, preferably R¹², is independently an electron withdrawing group, preferably selected from the group consisting of be CN, F, NO₂, ester, alkyl acyl, aryl acyl, amide, formyl, SO₂R, such as SO₂CF₃, SO₂Me, or SO₂NH₂, SF₅, NR₃⁺, pyridinium, halogen, and fluorinated alkyls or aryls, such as CF₃, wherein embodiments described above for formula (V) are most preferred; and

the remaining R¹ to R⁵, R⁷ to R¹³ (not selected as above), are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl and substituted or unsubstituted C₂-C₂₀-alkenyl; wherein the one or more substituents, if present in one or more of R³-R⁸, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; (meth)acrylate; tosyl; NH₂; and OH; and/or wherein two adjacent groups of R⁵-R⁸ may be linked to each other to form a fused ring structure, preferably, a fused aromatic C₆-ring,
   wherein
preferably one of the remaining R¹ to R⁵, R⁷ to R¹³ comprises or is selected from the group consisting of ammonium, polyethylene glycol, OH, NH₂, SO₂NH₂, sulfonic acid, carboxylic acid; boronic acid; phosphonic acid, phosphates; phosphonates; sulfates; sulfonates; and carboxylates, and preferably the other of the remaining R¹ to R5, R⁸ and R¹⁰ to R¹³ are H;
and Z is N or C, wherein if Z is N, R⁴ is absent.

The photoinitiator may be selected from the following compounds

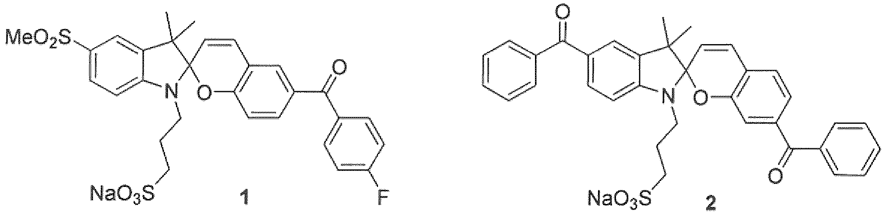

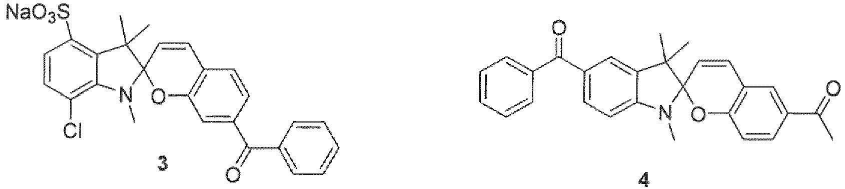

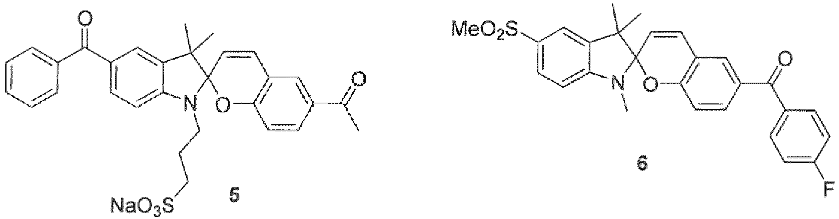

A colorless spiropyran dual color photoinitiator opens to the respective merocyanine form upon absorption of UV-light. The merocyanine form typically has a strong absorption between 550 nm and 650 nm and quickly reverts back to the spiropyran form, which is crucial for the xolography process. In an aqueous environment, especially at a lower pH, such as pH 7-8, the merocyanine may act as a base to form the protonated phenol form. The protonated merocyanine typically shows an absorption around 450 nm and switches back to the spiropyran form slowly or not at all. Furthermore, the protonated merocyanine shows only little or no reactivity as a photoinitiating species.

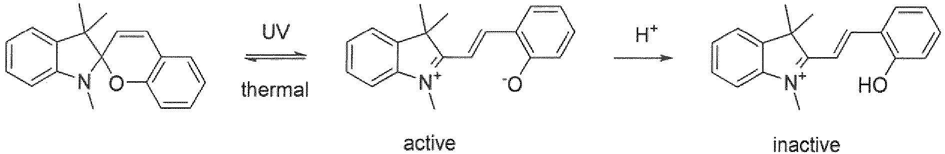

While the above description holds for most spiropyran/merocyanine systems, surprisingly spiropyrans/merocyanines with an acceptor in the para position with respect to the oxygen atom, were found to remain deprotonated and show efficient photoinitiation in a dual color process.

The polymerizable compound may comprise at least one polymerizable group selected from the group consisting of acrylate, methacrylate, acrylamide, methacrylamide, norbornene, maleimide, vinyl, and thiol.

In addition or alternatively, the polymerizable compound may comprise a backbone and at least one polymerizable group bound to the backbone, wherein the backbone may comprise at least one selected from the group consisting of polyethyleneglycol, polyether, polypropyleneglycol, alkyl, synthesized proteins, gelatin, hyaluronic acid, and chitosan alginate. The backbone may have a degree of functionalization from 1-100%, preferably 5-98, more preferably 10-95, most preferably 60-90. The molecular weight of the backbone can be 1kDa-5MDa, preferably 10-200 kDa.

Alternatively, the polymerizable compound may be free of a backbone, for example, may be acrylic acid or a salt thereof, preferably sodium acrylate.

The polymerizable starting material may further comprise an acid, preferably selected from the group consisting of HCl, H₃PO₄, KH₂PO₄, NaH₂PO₄, H₂SO₄, NaHSO₄, KHSO₄, a carboxylic acid, preferably acetic acid, formic acid, benzoic acid, a sulfonic acid, and a phosphonic acid.

The polymerizable starting material may further comprise a base, preferably selected from the group consisting of K₂HPO₄, K₃PO₄, KHCO₃, K₂CO₃, KCH₃COO, KHCOO, Na₂HPO₄, Na₃PO₄, NaHCO₃, Na₂CO₃, NaCH₃COO, NaHCOO, an amine, a carboxylic acid salt, a sulfonic acid salt, and a phosphonic acid salt.

The polymerizable starting material may further comprise a buffer, wherein the buffer comprises an acid and a base, wherein
- the acid is selected from the group consisting of HCl, H₃PO₄, KH₂PO₄, NaH₂PO₄, H₂SO₄, NaHSO₄, KHSO₄, a carboxylic acid, preferably acetic acid, formic acid, benzoic acid, a sulfonic acid, and a phosphonic acid; and
- the base is selected from the group consisting of K₂HPO₄, K₃PO₄, KHCO₃, K₂CO₃, KCH₃COO, KHCOO, Na₂HPO₄, Na₃PO₄, NaHCO₃, Na₂CO₃, NaCH₃COO, NaHCOO, an amine, a carboxylic acid salt, a sulfonic acid salt, and a phosphonic acid salt. Alternatively, the base can the bio-co-initiator.

The polymerizable starting material may have a viscosity from 10² mPa·s to 10⁹ mPa·s, preferably from 3·10³ mPa.s to 10⁸ mPa-s, more preferably 10³ mPa·s to 10⁶ mPa.s; most preferably 10⁴ mPa·s to 10⁵ mPa-s, preferably at the printing temperature, more preferably at 20°C. Alternatively, the polymerizable starting material may have a viscosity higher than 10⁹ mPa-s at the printing temperature, preferably at 20°C.

The polymerizable starting material may further comprise a rheology modifier. Especially, the rheology modifier may comprise or may be a monomer mixture and/or an oligomer mixture, preferably having a corresponding viscosity. The rheology modifier may be transparent. The rheology modifier may support a cured object (=shaped body), which may arise in a freely floating manner in the polymerizable starting material containing the rheology modifier. The rheology modifier may induce non-Newtonian flow properties to the starting material, such as shear-thinning or shear-liquefying flow properties, and/or induces a yield point which is greater than the static shear load of the shaped body.

A corresponding yield point of the polymerizable starting material which is greater than the static shear load by the shaped body is typically greater than or equal to 0.1 Pa, in particular 0.2 Pa, further in particular 0.3 Pa, further in particular 0.4 Pa, further in particular 0.5 Pa, further in particular o.6 Pa, further in particular 0.75 Pa, further in particular 1 Pa. A corresponding yield point of the polymerizable starting material may thus be in particular at least 0.1 Pa per cm³ of a working volume (which may be the local volume). For a working volume of 1 cm³, the yield point of the polymerizable starting material may thus be at least 0.1 Pa. For a working volume of 2 cm3, the yield point of the polymerizable starting material may thus be at least 0.2 Pa. The yield point may refer to a temperature of 20°C or the printing temperature.

The viscosity or yield point of the polymerizable starting material can be measured with a Kinexus Prime lab+ Rheometer, available from Netzsch (Erich NETZSCH B.V. & Co. Holding KG). A viscosity can be measured at a shear rate ranging from 0.001 s⁻¹ to 1000 s⁻¹, preferably the shear rate is 1 s⁻¹.

Examples of rheology modifiers, especially for adjusting non-Newtonian flow properties, are in the non-exhaustive list: 1) cellulose, modified cellulose, in particular cellulose esters, 2) polyacrylic acid and polyacrylic acid-polyacrylic acid ester copolymers, 3) polyacrylamides, 4) polyethylene oxide. Examples of rheology modifiers are in the non-exhaustive list: 1) inorganic (nano)particles, for example pyrogenic silica, natural and synthetic clay minerals, phyllosilicates, glass, 2) organically modified inorganic (nano)particles, 3) organic molecules, oligomers and polymers (urea derivatives, polysaccharides, polyacrylic acids, polyacrylates, polyamides, polyethers, polyurethanes, polyurea derivatives) and 4) urea-modified polyacrylates, polyethers, polyamides and polyurethanes. Examples of commercial organic rheology modifiers which may be used are in the non-exhaustive list: RHEOBYK 410, RHEOBYK 420, RHEOBYK 430, RHEOBYK 440, BYK-LP R21675^{,} RHEOBYK 7410CA, RHEOBYK 7420CA, RHEOBYK 7420ET (all available from BYK-Chemie GmbH, 46486 Wesel (DE)), JL-106 (available from Bomar Chem, 51 Greenwoods Rd, Torrington, CT 06790), Polyacrylic acid copolymer (Carbopol ETD 2020 NF), gelatine, Konjac Gum Powder, phytagel, carrageenan, HPMC, methylcellulose, ethyl cellulose, carboxymethylcellulose sodium salt, gum arabic, agar, sodium alginate, guar gum.

Rheology modifiers based on polymers may be crosslinked or branched.

It preferably applies to any rheology modifier that it is selected or used, for example with regard to its chemical and/or physical properties, concentration, etc., such that it does not lead, or scarcely leads, to clouding of the polymerizable starting material and/or of the shaped body after optical processing.

Rheology modifiers may be thixotropes. Suitable thixotropes which can be used as rheology modifier are, for example, urea derivatives; modified urea compounds such as Rheobyk 410 and Rheobyk-D 410 (available from BYK-Chemie GmbH), dimer and trimer fatty acids; polyether phosphates; oxidized polyolefins; hybrid oxidized polyolefins with polyamide; alkali-soluble/swellable emulsions; cellulose ethers; hydrophobically modified alkali-soluble emulsions; hydrophobically modified urethane based on ethylene oxide; sucrose benzoate; ester-terminated polyamides; tertiary amide-terminated polyamides; polyalkyleneoxy-terminated polyamides; polyether amides; acrylamidomethyl-substituted cellulose ester polymers; polyethyleneimine; polyurea; organoclays; hydrogenated castor oil; organic base salts of a clay mineral (e.g., montmorillonite) and other silicate-like materials; aluminum, calcium and zinc salts of fatty acids, such as lauric or stearic acid.

Thermally reversible gelling agents which can also be used as rheology modifiers are ester-terminated polyamides, tertiary amide-terminated polyamides, polyalkyleneoxy-terminated polyamides and polyether amides, and combinations thereof, are conceivable for use as thixotropes. Examples thereof are crystasense LP1, crystasense LP2, crystasense LP3, crystasense MP, crystasense HP4, crystasense HP5, rheoptima X17, rheoptima X24, rheoptima X38, rheoptima X58, rheoptima X73 and rheoptima X84 (available from Croda). Crystasense HP-5 is a preferred example of a thixotrope.

The polymerizable starting material comprises water. Accordingly, the polymerizable starting material may be an aqueous solution. The proportion of water may be between 5 and 99.9% by weight, in particular between 30 and 99.9% by weight, more particularly between 40 and 99.9% by weight, more particularly between 50 and 99.9% by weight, more particularly between 60 and 99.9% by weight, more particularly between 70 and 99.9% by weight, more particularly between 80 and 99.9% by weight, more particularly between 90 and 99.9%, more particularly between 90 and 95% by weight. In such embodiments, corresponding rheology modifiers, for example in the form of polyacrylic acid, gelatin, etc., may be soluble in water or the water-monomer or water-oligomer mixture or miscible with water or the water-monomer or water-oligomer mixture. A corresponding solubility or miscibility of the additives in or with water should be ensured in particular in a temperature range between 20 and 40° C., in particular between 25 and 37° C., alternatively between 20 and 30° C., more alternatively between 35 and 40° C.

Corresponding aqueous starting materials, in particular those which comprise one or more water-soluble and/or water-miscible additives, are selected in their composition in particular such that they are transparent. This is to be understood in particular as meaning that the starting material, even with additives, in particular in a wavelength range between 370 and 800 nm, in particular between 400 and 800 nm, more particularly between 450 and 800 nm, has a transmission of at least 30%, in particular at least 50%, more particularly at least 80%, more particularly at least 90% in the region of the irradiated light of first wavelength and/or in the region of the irradiated light of second wavelength. In this case, the transmission relates to an optical path length according to the Lambert-Beer law of 10 mm. A corresponding transmission should be ensured in particular in a temperature range between 20 and 40° C., in particular between 25 and 37° C., alternatively between 20 and 30° C., more alternatively between 35 and 40° C.

Corresponding aqueous starting materials, in particular those which comprise one or more water-soluble and/or water-miscible additives/rheology modifiers, are selected in their composition in particular such that they have a pH in the range between 5 and 10, in particular between 6 and 9, more particularly between 7 and 8, more particularly of 7.4. In this way, an undesired precipitation of additives/rheology modifiers and/or an undesired emulsion formation can be prevented or at least reduced. The pH can be adjusted or stabilized by adding a buffer, such as, for example, via a phosphate-buffered salt solution, PBS for short. A corresponding pH should be ensured in particular in a temperature range between 20 and 40° C., in particular between 25 and 37° C., alternatively between 20 and 30° C, more alternatively between 35 and 40° C.

As a further conceivable additive, the starting material may comprise one or more of the following gel formers, which may likewise serve as rheology modifiers. A gel former may be, for example, a polymer, in particular a polymer with carboxylic acids, such as, for example, polyacrylic acid, or crosslinked polyacrylic acid; or a polyvinyl alcohol or a derivative thereof; or a polysaccharide or a derivative thereof; or a peptide or protein or a derivative thereof, in particular gamma-carrageenan; or gelatin or a derivative thereof. The addition of a rheology modifier has proven to be particularly advantageous if the starting material comprises a polyethylene glycol diacrylate derivative (PEGDA), hydroxyethyl methacrylate (HEMA), acrylic acid salt, sodium acrylate, acrylic acid, NIPAM, bisacrylamide, acrylamide, in particular with a proportion of at least 10% by weight, in particular at least 20% by weight, more particularly at least 30% by weight, more particularly at least 40% by weight, more particularly at least 50% by weight, more particularly at least 60% by weight, more particularly at least 70% by weight, more particularly at least 80% by weight, more particularly at least 90% by weight.

Preferably, the rheology modifier may be an inorganic material, an organic artificial material, a biomolecule or combination or mixture thereof. Inorganic materials may be particles, preferably functionalized particles. Organic artificial materials can be for example a polymer or copolymer of acrylic acid, pentaertythritol tetraacrylat, polyethyleneglycol diacrylate, c1-c20 alkyl acrylate; urea derivatives, preferably at least two urea motifs are covalently linked to each other. Biomolecules may be gelatin, konjac gum powder, phytagel, carrageen, HPMC (hydroxypropylmethylcellulose), methylcellulose, ethylcellulose, Carboxymethylcellulose sodium salt, gum arabic, agar, sodium alginate, guar gum. Sodium salts can always be other cations, preferably dicationic Mg²⁺ Ca²⁺.

The rheology modifier can be removed in a post processing step. The rheology modifier may be transparent in the mixture at the given pH of the mixture.

The polymerizable starting material may further comprise a further co-initiator, preferably an iodonium salt.

The iodonium salt may have the following formula (VII)

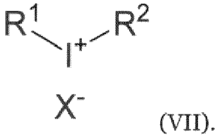

In formula (VII), R¹ and R² are independently selected from substituted or unsubstituted aryl, preferably phenyl or phenyl substituted with methoxy groups; and

X⁻ is an anion, preferably a hard anion, more preferably selected from the group consisting of Cl-, F⁻, SO₄²⁻, acetate, formate, carboxylate, sulphonate, and phosphate.

The polymerizable starting material may further comprise a nutrient, preferably selected from the group consisting of a vitamin, a sugar, preferably glucose, an amino acid, a growth factor, a protein, a carbohydrate, a fatty acid, a fatty acid ester, or a mixture of two or more thereof.

The polymerizable starting material may further comprise a water-miscible solvent, preferably selected from the group consisting of an alcohol, DMSO and polyethylene glycol.

The polymerizable starting material may further comprise other additives.

Preferably the concentration of each ingredient in the polymerizable starting material is low enough to obtain a colorless formulation, with an absorbance <1, preferably <0.5 at the first and/or second wavelength for an optical path length corresponding to the dimension of the container along the direction the respective light has to travel, preferably 10 mm.

Any combinations of embodiments, preferred ranges and/or moieties, in particular, preferred moities of the invention are particularly preferred.

### Brief description of drawings

In the following, further design examples are explained with reference to figures in a drawing, wherein
Fig. 1 shows a schematic representation of an embodiment of the process according to the invention.
Fig. 2 is a schematic view of a device for processing an optically reactive material from above.
Fig. 3 is a schematic view of the device of Fig. 2 from the side.

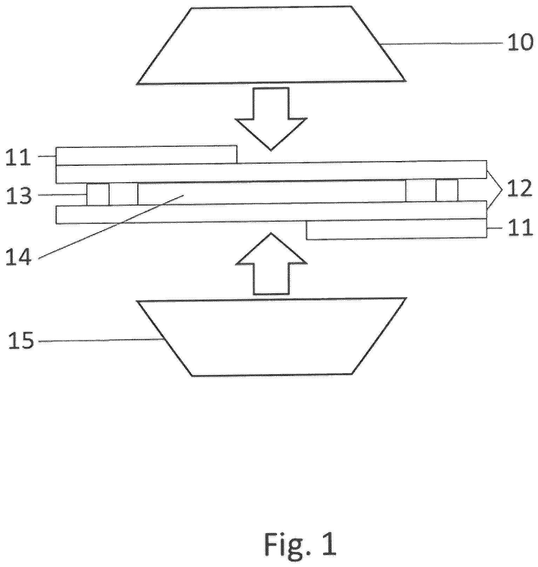

Figure 1 schematically shows an embodiment of the invention. By means of a first light source 10 a light with a first wavelength is generated and irradiated onto a structure comprising a curable composition 14. The assembly is a layered assembly comprising a light-blocking layer 11 and two transparent layers 12. The assembly further comprises a spacer 13. In the space formed by the two transparent layers 12 and the spacer 13, the curable composition 14 corresponding to the polymerizable starting material and containing one or more photoinitiator molecules according to the invention is introduced. The layered structure further comprises two light-blocking layers 11 arranged so that at least a portion of the curable composition 14 can be irradiated by both the light of the first wavelength generated by the first light source 10 and a light of a second wavelength generated by the second light source 15. The region of the curable composition 14 which can be irradiated both by light from the first light source 10 and by light from the second light source 15 is cured according to the mechanism described herein.

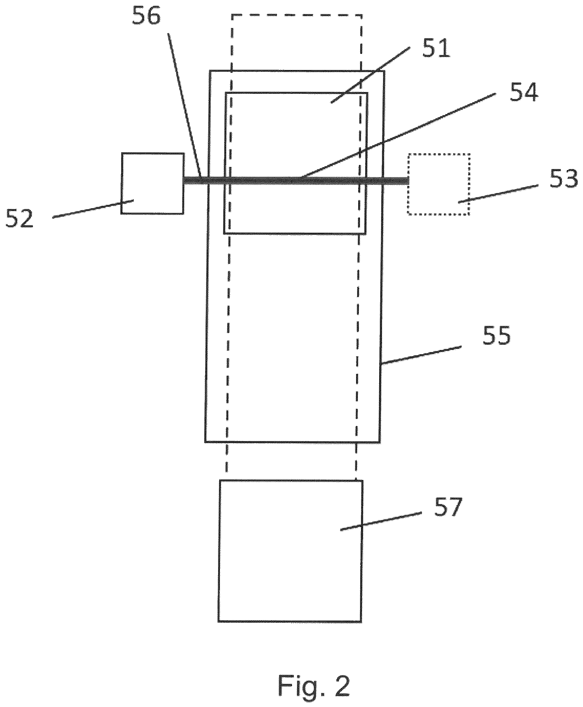

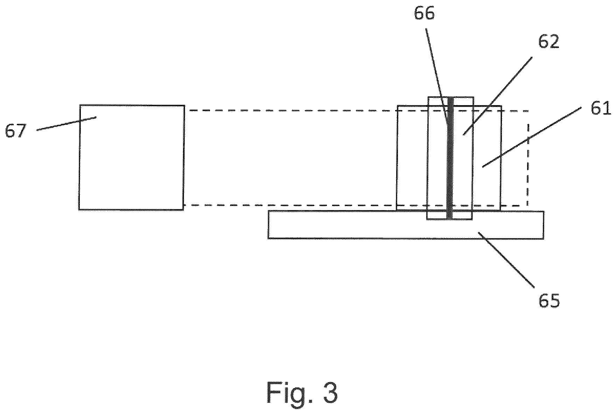

Figs. 2 and 3 show a schematic representation of an arrangement for a device for optical processing of an optically reactive material from above and from the side. A working volume is provided in a receiving container 51, 61, which is at least partially filled by a starting material. The starting material can comprise one or more substances, which can be solid, liquid or pasty. For processing, the starting material is irradiated with light of a first wavelength from a first light generator 52, 62 and optionally light of a first wavelength from a second light generator 53, which are irradiated in an overlapping manner in the working volume to trigger an optically activated reaction in a layer subvolume 54. The receiving container 51, 61, which is at least partially filled by a starting material may be moved along an axis for cuvette moving 55, 65 to shift the position of the subvolume 54 in the receiving container 51, 61 and in the starting material filled therein.

Alternatively, the first light generator 52, 62 and optionally the second light generator 53 may be moved along an axis to shift the position of the subvolume 54 in the receiving container 51, 61 and in the starting material filled therein (not shown in Figs. 2 and 3).

The first light generator 52, 62 and optionally the second light generator 53 may be a light sheet generator.

Depending on the current position of the irradiation area 56, 66 (light sheet), the light of the second wavelength is projected with the aid of a projector 57, 67 into the layered part volume currently irradiated with the light of the first wavelength (projector or projection image). This means that the projection plane or projection volume of the projector 57, 67 is located in the layer subvolume that is currently being irradiated with the light of the first wavelength. The light of the first wavelength (light section) and the light of the second wavelength (light projection) thus at least partially overlap spatially or in a projection plane of the projector 57, 67 in a macroscopic partial layer volume of the starting material, which as a partial volume of the working volume which is just being irradiated by means of the light section.

In this way, at least one material property of the starting material is changed in the currently irradiated layered partial volume, for example to the effect that the original starting material hardens. In this case, polymerization can be triggered in the starting material due to the coincidence of the light of the two wavelengths. In this way, it is possible, for example, to continuously produce a three-dimensionally shaped body layer by layer in the working volume. The three-dimensional shaping of the body is influenced and determined with the aid of the projection of the projector 57, 67 formed in the respective layer volume.

### Examples

Buffer solutions are prepared as follows:

### 1M MES pH6.o:

2-(*N*-Morpholino)ethanesulfonic acid (19.5 g) was dissolved in deionized water (75 mL) and 3 M hydrochloric acid was added until pH6.0 is reached. The volume was filled to 100 mL with deionized water.

### 1M BisTris pH7.0:

Bis(2-hydroxyethyl)amino-tris(hydroxymethyl)methan (20.9 g) was dissolved in deionized water (75 mL) and 3 M hydrochloric acid was added until pH7.0 is reached. The volume was filled to 100 mL with deionized water.

### 1M BisTris pH7.4:

Bis(2-hydroxyethyl)amino-tris(hydroxymethyl)methan (20.9 g) was dissolved in deionized water (75 mL) and 3 M hydrochloric acid was added until pH7.4 is reached. The volume was filled to 100 mL with deionized water.

### 1M BES pH8.0:

*N,N*-Bis(2-hydroxyethyl)-2-aminoethanesulfonic acid (21.3 g) was dissolved in deionized water (75 mL) and 3 M hydrochloric acid was added until pH8.o is reached. The volume was filled to 100 mL with deionized water.

### 1M TEOA pH9.0:

Tris(2-hydroxyethyl)amine (14.9 g) was dissolved in deionized water (75 mL) and 3 M hydrochloric acid was added until pH9.0 is reached. The volume was filled to 100 mL with deionized water.

### Example Formulation 1 (printed with 375 nm & 500-650 nm)

Gelatine-methacryloyl (1 g) and 1 (2 mg) were added to a mixture of deionized water (4 mL) and 1M BisTris pH7.4 buffer (5 mL). The mixture was vortexed at 40 °C until homogenization, centrifuged and was used after gelation.

### Example Formulation 2 (printed with 375 nm & 500-650 nm)

Gelatine (0.5 g) and **3** (2 mg) were added to a mixture of deionized water (5 mL) and 1 M BES pH8.o buffer (5 mL). The mixture was vortexed at 40 °C until homogenization and polyethylene glycol diacrylate (M_{w}: 575 g/mol; 1.5 g) was added. The mixture was centrifuged and was used after gelation.

### Example Formulation 3 (printed with 405 nm & 500-650 nm)

To a mechanically stirred mixture of poly(acrylic acid) interpolymer (Carbopol ETD 2020 NF; 24 mg) and deionized water (2.7 mL) 1 M TEOA pH9.0 buffer (3.3 mL), polyethylene glycol diacrylate (M_{w}: 700 g/mol; 4.0 g), and photoinitiator **4** (2 mg) was added. The mixture was stirred until homogenization, centrifuged and was used directly.

### Example Formulation 4 (printed with 375 nm & 500-650 nm)

To a mechanically stirred mixture of poly(acrylic acid) interpolymer (Carbopol ETD 2020 NF; 24 mg) and deionized water (2.7 mL) was added 1M TEOA pHg.o buffer (3.3 mL), polyethylene glycol diacrylate (M_{w}: 700 g/mol; 4.0 g), and photoinitiator **6** (2 mg). The mixture was stirred until homogenization, centrifuged and was used directly.

### Example Formulation 5 (glass-slide experiment with 375 nm & 500-650 nm)

To a mechanically stirred mixture of kappa-Carrageene (30 mg), deionized water (4.2 mL) and 1 M MES pH6.o buffer (5 mL) was added sodium acrylate (0.5 g), photoinitiator **1** (2 mg) and hyaluronic acid methacrylate (0.3 g) at 40 °C. The mixture was stirred until homogenization, centrifuged and was used directly.

### Example Formulation 6 (glass-slide experiment with 375 nm & 500-650 nm)

To a mechanically stirred mixture of diphenyliodonium chloride (6 mg), lithium triphenyl (n-butyl) borate (20% aqueous solution; 0.5 g), deionized water (4.2 mL) and 1 M BES pH8.o buffer (5 mL) was added hydroxypropyl methylcellulose (50 mg), photoinitiator **1** (2 mg), acrylamide (1 g) and *N,N*'-methylenebisacrylamide (33 mg). The mixture was stirred until homogenization, centrifuged and was used directly.

### Example Formulation 7 (glass-slide experiment with 375 nm & 500-650 nm)

A modified urea (RHEOBYK-7420 ET; 0.3 g) and **6** (2 mg) were added to a mixture of deionized water (0.4 mL), 1 M TEOA pH9.0 buffer (3.3 mL) and ethanol (3 mL). The mixture was stirred until homogenization and polyethylene glycol diacrylate (M_{w}: 575 g/mol; 1.5 g), N-isopropylacrylamid (1.0 g), and 2-hydroxyethyl methacrylate (0.5 g) were added. The mixture was centrifuged and was used directly.

### Example Formulation 8 (glass-slide experiment with 375 nm & 500-650 nm)

Alginate methacrylate (0.5 g), sodium carboxymethyl cellulose (50 mg) and 1 (2 mg) were added to a mixture of deionized water (4 mL) and 1 M BisTris pH7.0 buffer (5 mL). The mixture was vortexed at 40 °C until homogenization and a mixture of L-methionin (300 µg), folic acid (40 µg), potassium chloride (4 mg), and D-glucose (45 mg) in deionized water (1 mL) was added. The mixture was homogenized, centrifuged and was used directly.

### Example Formulation 9 (glass-slide experiment with 375 nm & 500-650 nm)

Gelatine-methacryloyl (1 g) and **1** (2 mg) was added to a mixture of deionized water (2.7 mL) and 1M BisTris pH7.4 buffer (5.0 mL). The mixture was vortexed at 40 °C until homogenization and polyethylene glycol diacrylate (Mw: 575 g/mol; 1.0 g) and N-isopropylacrylamid (0.3 g) were added. The mixture was homogenized, centrifuged and was used after gelation.

### Example Formulation 10 (glass-slide experiment with 405 nm & 500-650 nm)

Gelatine-methacryloyl (1 g) and **5** (2 mg) was added to a mixture of deionized water (1.8 mL) and 1 M TEOA pH9.0 buffer (6.7 mL). The mixture was vortexed at 40 °C until homogenization and sodium acrylate (0.5 g) was added. The mixture was homogenized, centrifuged and was used after gelation.

### Example Formulation 11 (glass-slide experiment with 375 nm)

Gelatine-methacryloyl (1 g), hyaluronic acid methacrylate (0.2 g) and 1 (2 mg) were added to a mixture of deionized water (6.7 mL) and 1 M BisTris pH7_{.}0 buffer (1.0 mL). The mixture was vortexed at 40 °C until homogenization and lithium triphenyl (*n-*butyl) borate (20% aqueous solution; 0.5 g), L-alanyl-L-glutamine dipeptide (4.3 mg), bovine serum albumin (5% aqueous solution, 0.5 g), insulin (0.625 mg/mL aqueous solution, 0.1 g) was added. The mixture was stirred until homogenization, centrifuged and was used directly.

### Example Formulation 12 (glass-slide experiment with 375 nm)

Gelatine-methacryloyl (0.5 g), hyaluronic acid methacrylate (0.4 g), poly(acrylic acid) interpolymer (Carbopol ETD 2020 NF; 12 mg) and 1 (2 mg) were added to a mixture of deionized water (6.4 mL) and 1 M BisTris pH7.4 buffer (2.0 mL). The mixture was vortexed at 40 °C until homogenization and lithium triphenyl (n-butyl) borate (20% aqueous solution; 0.3 g), selenic acid (0.625 µg/mL aqueous solution, 0.1 g), human transferrin (0.625 mg/mL aqueous solution, 0.1 g), linoleic acid (0.5 mg/mL aqueous solution, 0.1 g), insulin-like growth factor 1 (50 µg/mL aqueous solution, 4 µL), fibroblast growth factor 2 (12.5 µg/mL aqueous solution, 4 µL), heparin (0.1 mg/mL aqueous solution, 50 µL), and fibronectin (1 mg/mL aqueous solution, 100 µL) were added. The mixture was stirred until homogenization, centrifuged and was used directly.

### Example Formulation 13 (glass-slide experiment with 565 nm, same light source from top and bottom in figure1)

Polyethylene glycol diacrylate (M_{w}: 575 g/mol; 4 g) and water (1.0 g) were added to a solution of 2',4',5',7'-tetrabromofluorescein disodium salt (eosin-Y, CAS: 17372-87-1; 3 mg) in 1 M BisTris pH7.4 buffer (5.0 mL). The mixture was stirred until homogenization, centrifuged and was used directly.

Formulations 1-4 were printed in a setup with a light sheet, a projector and a moved cuvette as shown in Figs. 2 and 3. The following objects have been printed:
A cube in the dimensions of 8 mm x 8 mm x 8 mm comprising a channel with a width of 1.5 mm which connects three neighboring faces of the cube via the center.

A plate of the dimensions of 7 mm x 12 mm and a thickness of 1.5 mm, where cylindrical columns with an aspect ratio of 2:1 (height:width) are printed on one side of the plate. The columns have increasing diameters ranging from 50 µm to 1000 µm.

A cube in the dimensions of 8 mm x 8 mm x 8 mm with a regular open pore structure and a wall thickness of 1 mm (gyroid structure).A cube in the dimensions of 8 mm x 8 mm x 8 mm with a regular open pore structure and a wall thickness of 2 mm (gyroid structure).

A model of "The Thinker" by Aguste Rodin in a height of 11.5 mm.

A cube in the dimensions of 8 mm x 8 mm x 8 mm, wherein each pair of opposing faces is connected by 9 straight cylindrical channels with a diameter of 1.2 mm, forming a regular porous structure.

Formulations 5-9 and 11-12 were polymerized with light of two wavelengths in a setup according to Figure 1 using 375 nm as the first wavelength and 565 nm as the second wavelength. The solidification is observed first in the area where the light of both light sources intersects.

Formulation 10 was polymerized with light of two wavelengths in a setup according to Figure 1 using 405 nm as the first wavelength and 565 nm as the second wavelength. The solidification is observed first in the area where the light of both light sources intersects.

Formulation 13 was polymerized with light of only one wavelength in a setup according to Figure 1 using two 565 nm light sources as light source 10 and 15. The solidification is observed first in the area where the light of both light sources intersects.

In a photopolymerization based on a type II initiation mechanism comprising an amine co-initiator, the initiation proceeds via a photoelectron transfer reaction, where an electron is transferred from the electron-rich amine to the excited state of the electron deficient photoinitiator. A common parameter to describe amines is the pKa value, where a high pKa value is typically associated with a high electron density at the nitrogen resulting in a high basicity. Since a high electron density would lead to a high reactivity for the photoelectron transfer, one would typically choose an amine with a high pKa value, such as triethanolamine as the co-initiator. Surprisingly this rule does not hold, when the aqueous environment has a pH around neutral, e.g. between 5 and 9. To give an illustrative example, the usually very reactive triethanolamine does not show any reactivity at pH 7. In such systems it has been found that the reactivity is increased by using a co-initiator with a lower pKa value, such as 7.5 to 4.5

The features disclosed in the above description, claims and drawing may be relevant to the realisation of the various designs either individually or in any combination.

## Claims

1. A process for volumetric printing of a shaped body comprising locally polymerizing a starting material, comprising:
- providing a polymerizable starting material, wherein the polymerizable starting material comprises
- a photoinitiator;
- a polymerizable compound;
- a bio-co-initiator; and
- water; and
- the polymerizable starting material has a pH value from 5 to 9;
- photopolymerizing the polymerizable starting material in a local volume by irradiating light of a first wavelength.

2. The process according to claim 1, wherein
- the photoinitiator is converted by sequential optical excitation into a reactive state in which the photoinitiator locally triggers polymerization of the polymerizable starting material;
- the photopolymerizing comprises irradiating the starting material in the local volume further with light of a second wavelength, different from the first wavelength, into the local volume;
- the photoinitiator is converted, due to the absorption of the light of the first wavelength, from an initial state in which the photoinitiator substantially does not absorb the light of the second wavelength, into an intermediate state with changed optical properties compared to the initial state, such that the photoinitiator in the intermediate state absorbs the light of the second wavelength; and
- the photoinitiator is transferred from the intermediate state to the reactive state due to the absorption of the light of the second wavelength, which triggers the polymerization locally.

3. The process according to claim 1 or claim 2, wherein
- the light of the first wavelength is irradiated into the local volume from a first direction and from a second direction different from the first direction;
- the light of the first wavelength irradiated into the local volume from the first direction has a first intensity or a first intensity distribution;
- the light of the first wavelength irradiated into the local volume from the second direction has a second intensity or a second intensity distribution.

4. The process according to any of the claims 1 to 3, wherein the polymerizable starting material has a pH value from 7 to 8.

5. The process according to any of the claims 1 to 4, wherein the bio-co-initiator has a pKa value from 4.5 to 7.5.

6. The process according to any of the claims 1 to 5, wherein the bio-co-initiator is an amine comprising at least one beta-hydroxy group or a borate salt comprising a borate anion, preferably a triarylalkylborate anion, and a cation selected from the group consisting of H⁺,D⁺, Li⁺, Na⁺, K⁺, Mg²⁺, and Ca²⁺.

7. The process according to claim 6, wherein the amine comprising at least one beta-hydroxy group is a tertiary amine comprising at least one beta-hydroxy group.

8. The process according to claim 6 or 7, wherein the amine comprising at least one beta-hydroxy group is an amine comprising at least four beta-hydroxy group.

9. The process according to any of the claims 6 to 8, wherein the bio-co-initiator may comprise at least one beta-sulfonate group.

10. The process according to any of the claims 6 to 9, wherein the bio-co-initiator is selected form the following compounds

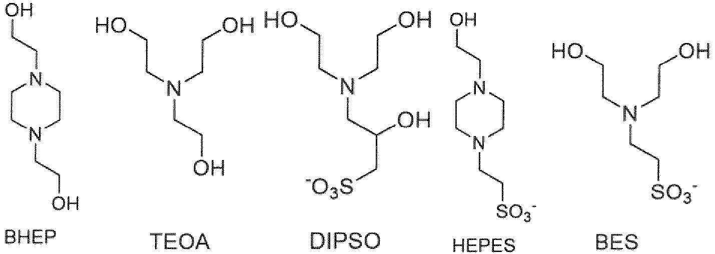

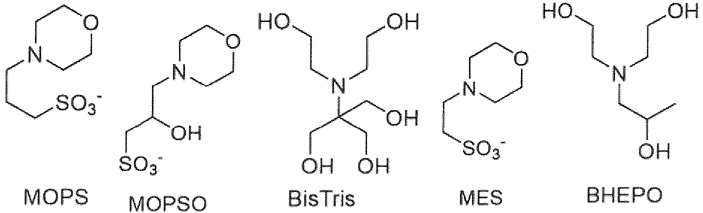

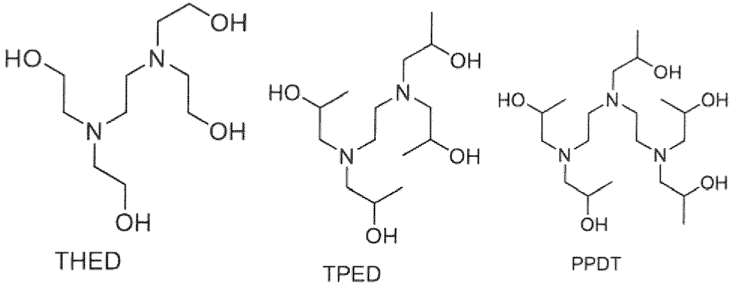

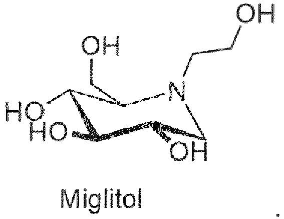

11. The process according to any of the preceding claims, wherein the photoinitiator includes a structural motif selected from the group consisting of a spiropyran structural motif, a spironaphthoxazine structural motif and a naphthopyran structural motif.

12. The process according to claim 11, wherein the photoinitiator further comprises at least one group selected from the group consisting of ammonium, polyethylene glycol, OH, NH₂, SO₂NH₂, sulfonic acid, carboxylic acid; boronic acid; phosphonic acid, phosphates; phosphonates; sulfates; sulfonates; and carboxylates.

13. The process according to any of the preceding claims, wherein the polymerizable compound comprises at least one polymerizable group selected from the group consisting of acrylate, methacrylate, acrylamide, and methacrylamide, norbornene, maleimide, vinyl, and thiol;
and/or
the polymerizable compound comprises a backbone and at least one polymerizable group bound to the backbone, wherein the backbone comprises at least one selected from the group consisting of polyethyleneglycol, polyether, polypropyleneglycol, alkyl, synthesized proteins, gelatin, hyaluronic acid, and chitosan alginate.

14. The process according to any of the preceding claims, wherein the polymerizable starting material further comprises an acid, preferably selected from the group consisting of HCl, H₃PO₄, KH₂PO₄, NaH₂PO₄, H₂SO₄, NaHSO₄, KHSO₄, a carboxylic acid, preferably acetic acid, formic acid, benzoic acid, a sulfonic acid, and a phosphonic acid.

15. The process according to any of the preceding claims, wherein the polymerizable starting material further comprises at least one selected from the group consisting of a rheology modifier, a further co-initiator, a nutrient, and a water-miscible solvent.
